# EUROPEAN PATENT SPECIFICATION

(11) **EP 0 329 336 B1**
(45) Date of publication and mention of the grant of the patent: **11.09.1996**
(21) Application number: 89301267.4
(22) Date of filing: 09.02.1989
(51) Int. Cl.: B29C 59/08, B32B 27/16

(54) **Process for manufacturing a metallised polyolefin film and resulting film**
Verfahren zum Herstellen eines metallisierten Polyolefinfilms und daraus resultierender Film
Procédé pour la fabrication d'un film métallisé en polyoléfine et film qui en résulte

(30) Priority: 16.02.1988 US 156127
(43) Date of publication of application: 23.08.1989
(73) Proprietor: MOBIL OIL CORPORATION, New York New York 10017 (US)
(72) Inventor: Balloni, Riccardo, Fairport New York 14450 (US); Mount, Elridge Milford, III, Fairport New York 14450 (US); Keung, Jay Kin, Macedon New York 14502 (US)
(74) Representative: Colmer, Stephen Gary

(56) References cited:
- EP-A- 0 021 672
- EP-A- 0 211 433
- FR-A- 2 516 860
- US-A- 4 663 218
- DATABASE WPIL, accession no. 81-44716D [25], Derwent Publications Ltd, London GB; & JP-A-56 046 744 (TOYOBO K.K. )
- PATENT ABSTRACTS OF JAPAN, vol. 10, no. 148 (C-350)[2205], 29th May 1986; & JP-A-61 6268 (MATSUSHITA DENKI SANGYO K.K.) 11-01-1986
- PATENT ABSTRACTS OF JAPAN, vol. 11, no. 106 (C-414)[2553], 3rd April 1987; & JP-A-61 253 361 (MITSUBISHI PETROCHEM. CO., LTD) 11-11- 1986

## Description

This invention relates to a processe for manufacturing metallized polymeric films (claim 13) as well as the films resulting from the process claims 1 and 19. More particularly, the invention provides metallized, for example aluminized, polymeric films wherein the metal-adherent surface comprises flame treated semi-crystalline polyolefin, such as isotactic polypropylene, containing from 0 to 50 weight percent of non-crystalline polyolefin component(s).

The metallization of polymeric films for aesthetic and/or functional purposes is a well developed technology. Thus, G.B. 2111428 discloses a packaging material comprising an oriented film of polypropylene coupled with another olefinic polymer film, at least one of the films being coated with a lacquer for impermeability to gases and vapours and metallized on the face coupled with the other film. The document also discloses that the metallization can be carried out before laquering. In that case the film is first subjected to electric discharge or to an oxidizing flame or to chemical oxidation.

In accordance with the present invention, it has been found that a surface of a layer of polymeric material comprising at least one semicrystalline polyolefin can be flame treated prior to vacuum metallization to provide a level of film-metal adherence which is significantly greater either than that achieved by corona discharge treatment of such a surface prior to vacuum metallization or by flame treatment of an essentially non-crystalline polyolefin homopolymer/copolymer surface.

In accordance with the present invention, there is provided a metallized flexible film which comprises at least one layer of a polymeric material, the layer comprising at least one semicrystalline polyolefin, preferably in an amount of at least 60 weight percent, most preferably at least 80 weight percent, of the composition of the layer, containing from 0 to 50 weight percent of an amorphous polyolefin and having a surface treated, prior to metallization of that surface, by exposure to flame to enhance significantly the adhesion of the metal to the surface.

Preferably, the semicrystalline polyolefin comprises a substantially isotactic homopolymer having a degree of atacticity no more than 6 percent and possessing an average xylene soluble content of not more than 10 weight percent (measured in accordance with FDA CFR Reg. 177.1520(c)1.1), especially polypropylene homopolymer. Advantageously, the semicrystalline polymer comprises polypropylene homopolymer which is from 80 to 100%, preferably from 95 to 96%, isotactic. When blends of isotactic homopolymer, such as polypropylene, are employed the blend preferably includes not more than 50 weight percent of a second isotactic homopolymer having a degree of atacticity of from 6% to 15%. The preferred polypropylene homopolymer possesses a melt index from 2 to 10 grams/10 minutes, and preferably a melt index from 3.5 to 6 grams/10 minutes.

In addition to the or each semicrystalline polymer the layer can also further comprise suitably not more than 34 weight percent, preferably not more than 20 weight percent, of a C₂ to C₄ polymer which promotes adhesion of metal to the surface of the layer. The C₂ to C₄ polymer may comprise a homo-, co-, or terpolymer; for example, a copolymer such as ethylene-propylene copolymer or ethylene-propylene-butene-1 terpolymer.

In one embodiment of the invention, the layer further comprises not more than 34 weight percent of a C₂ to C₄ polymer which promotes adhesion of metal to the surface of the layer and a second substantially isotactic homopolymer having a degree of acacticity from 6% to 15%, provided that the at least one substantially isotactic homopolymer is present in at least 50 weight percent.

Desirably, the treated surface is a gloss surface, preferably, wherein the surface possesses a gloss of at least 75%, most preferably at least 85%, at 45° (measured in accordance with ASTM-D245T).

The film can also include a core layer, one side of which is contiguous with the layer comprising at least one semicrystalline polyolefin, of isotactic polymer such as isotactic polypropylene homopolymer. The film can also include a heat sealable layer, one side of which is contiguous with the core layer.

This invention also provides a process for metallising a flexible film which comprises at least one layer of a polymeric material, which process comprises
(a) providing a layer comprising at least one semicrystalline polyolefin and containing from 0 to 50 weight percent of an amorphous polyolefin;
(b) treating a surface of the layer, prior to metallisation of that surface, by exposure to flame to enhance significantly the adhesion of the metal to the surface; and
(c) applying metal to the flame treated surface under vacuum metallising conditions.
Suitably, the semicrystalline polyolefin is a substantially isotactic polypropylene homopolymer. It is desirable that the film is oriented by stretching prior to steps (b) and (c). The flame treating of the surface imparts an energy density from 30 to 60 dynes/cm to this surface, preferably from 35 to 55 dynes/cm.

This invention further provides the use of flame treatment to enhance the adhesion of metal to a surface comprising a major amount of a semicrystalline polyolefin.

In a preferred embodiment of the metallized, flexible film of the present invention, the film is provided as a laminate structure in which a core layer of substantially isotactic polypropylene is contiguous on one side with a layer comprising the same isotactic polypropylene of the core layer or a blend thereof with no more than 40 weight percent, and preferably no more than 20 weight percent, polyolefin copolymers and contiguous on the other side with a layer of heat sealable resin.

Suitable resins for use in any heat sealable layer include a blend of poly(1-butene) and a copolymer of ethylene or propylene and a higher olefin as disclosed in U.S. Patent 4,275,120; a blend comprising a copolymer of ethylene and a higher olefin and a different copolymer of higher olefins as disclosed in U.S. Patent 4,297,411; an interpolymer of propylene and two different higher alpha-olefins; a copolymer of butene-1 and a higher alpha-olefin or an interpolymer of ethylene, propylene and a higher olefin as disclosed in U.S. Patent 4,339,497; a heat-sealable acrylic resin on a primer layer as disclosed in U.S. Patent 4,439,493; and vinylidene chloride polymer on a primer layer as disclosed in U.S. Patent 4,495,027.

The laminate structure is advantageously fabricated by any conventional coextrusion procedure. In a typical structure, the coextruded laminate can have a total thickness of about 1.78 x 10⁻³ cm (0.7 mils) with the surface layers contributing from 2.5 to 9 percent of the total weight of the film. Following coextrusion, the laminate is biaxially oriented in a known manner and thereafter flame treated and vacuum metallized to provide a metallized, flexible film of this invention.

Flame treatment procedures contemplated include those disclosed in U.S. Patent 2,648,097; 3,028,622, 3,255,034, 3,347,697; 3,375,126; and 4,239,827. In one suitable type of flame treatment operation the surface of the oriented film which is to be metallized is continuously passed through, or in close proximity to, a flame at a rate sufficient to provide an exposure time from 0.0005 to 0.1 seconds. Typically, the intensity of the flame treatment is such as to impart an energy density of from 30 to 60 dynes/cm and preferably from 35 to 55, for example 45, dynes/cm, to the treated side(s) of the film.

Metallization is carried out in accordance with known vacuum metallization procedures using metals such as aluminium, zinc, copper (and alloys thereof such as bronze), silver and gold, aluminium being preferred for its economy, especially where packaging applications are concerned. A metal layer ranging in thickness from 100 to 500 angstroms is generally entirely suitable.

The resulting film possesses excellent metal to resin adherence as well as a high degree of resistance to metal fracture, especially in extrusion lamination with polyethylene. As such, the metallized film of this invention is particularly useful in flexible packaging applications to provide enhanced moisture barrier protection as well as an attractive appearance for the packaged goods.

The following Examples illustrate the invention.

### EXAMPLE 1

A highly crystalline polypropylene homopolymer (melt flow of 4.2 and DSC melting point of about 162°C) core layer was coextruded with an upper metal-receiving layer of the same polypropylene and a lower heat sealable layer of a resin comprising ethylene-propylene copolymer containing 0.4 weight percent anti-blocking agents and 800 ppm erucamide and 100 ppm oleamide slip agents. The coextrudate was then quenched at 27 to 43°C (80° to 110°F), reheated to 116 to 138°C (240° to 280°F), and stretched in the machine direction 4 to 8 times using transport rolls operating at different speeds. After the desired machine direction orientation, the film was transversely oriented 7 to 10 times, at an appropriate temperature profile, in a tenter frame. The resulting film had an overall thickness of 2.03 x 10⁻³ cm (0.80 mil) with the core layer 1.6 x 10⁻³ cm (0.63 mil), the top layer 7.62 x 10⁻⁵ cm (0.03 mil) and the bottom layer 3.56 x 10⁻⁴ cm (0.14 mil). The upper layer was flame treated to various treatment levels (see Table 1).

The flame treated film was next metallized by vacuum deposition of aluminium and tested for metal pick off by SCOTCH 610 tape (3M Corp.). To test the metal adhesion, strips of SCOTCH 610 tape were applied to the metallized surface and the tape was pulled manually. At extreme testing conditions, the tape pull test was repeated three times with fresh tape applied to the same area. The metal pick-off was then recorded for comparison. Flame treatment samples with 33 to 40 dyne/cm treatment levels showed good metal adhesion after three SCOTCH 610 tape pull tests.

Table 1 shows the effect of various levels of flame treatment on the extend of metal pick-off.

**Table 1**

| % Metal Pick-Off At Various Levels Of Flame Treatment | |
|---|---|
| Treatment (dynes/cm) | % Metal Pick-Off |
| 33 | 30 to 50 |
| 34 | 20 to 40 |
| 36 | 20 to 50 |
| 38 | 15 to 50 |
| 40 | 40 to 50 |

### COMPARATIVE EXAMPLE 2

The procedure of Example 1 was substantially repeated except that the upper layer of the stretched film was treated by corona discharge at various levels.

Table 2 shows the effect of corona discharge treatment on the percentage of metal pick-off. At every level of flame treatment carried out in Example 1, the resulting metallized film demonstrated significantly superior metal adhesion than the corona discharge treated film of this Example.

**Table 2**

| % Metal Pick-Up At Various Levels Of Corona Discharge Treatment | |
|---|---|
| Treatment (dynes/cm) | % Metal Pick-Off |
| 32 | 80 to 90 |
| 35 | 70 to 90 |
| 37 | 80 to 95 |
| 39 | 70 to 90 |

### EXAMPLES 3 TO 10

Example 1 was substantially repeated with a variety of metal-receiving layer compositions. The flame treatment in each example was 38 to 40 dynes/cm. To test for observed metal fracture, the metallized film was laminated to another oriented polypropylene film employing a polyethylene adhesive. The polyethylene was cast at a 325 to 327°C (617° to 620°F) stock temperature at 10 #/ream poly weight on the metallized film and subsequently laminated to the other oriented polypropylene substrate by a nip. The laminate was microscopically examined for metal fracture, a phenomenon which appears as the crazing of the metal.

The result of the metal fracture study are summarized in the following Table:

**Table 3**

| Metal Fracture Observed With Various Metallized Substrates | | | | |
|---|---|---|---|---|
| EXAMPLE | COMPOSITION OF METALLIZED LAYER OR FILM | | | METAL FRACTURE |
| | RESIN NO. 1 | RESIN NO. 2 | RESIN NO. 3 | |
| 3 | 100 | - | - | None |
| 4 | 66 | 17 | 17 | None |
| 5 | 50 | - | 50 | None |
| 6 | 66 | 34 | - | None |
| 7 | 50 | 25 | 25 | None |
| 8 | 50 | 50 | - | 18% |
| 9 | - | 100 | - | 18% |
| 10 | - | - | 100 | 9.0% |
| RESIN NO. 1 = wt. parts highly crystalline polypropylene homopolymer having a xylene soluble content of about 3 to 4.5 wt. percent RESIN NO. 2 = wt. parts amorphous ethylene-propylene copolymer RESIN NO. 3 = wt. parts essentially amorphous crystalline homopolymer having a xylene soluble content of about 10 to 17 wt. percent. | | | | |

As this data shows, metal-receiving layers based on at least 50 weight percent homopolymer containing an average xylene soluble content or not more than about 10 weight percent (Examples 3, 4, 5, 6 and 7) exhibited essentially no metal fracture. However, when the amount of homopolymer was less than 50 weight percent (Examples 8 and 9) or exceeded the foregoing average xylene soluble content (Example 10), an unacceptable level of metal fracture was observed.

## Claims

1. A metallised, flexible film which comprises at least one layer of a polymeric material, the layer comprising at least one semicrystalline polyolefin containing from 0 to 50 weight percent of an amorphous polyolefin and having a surface treated, prior to metallisation of that surface, by exposure to flame to enhance significantly the adhesion of the metal to the surface.

2. A metallised film according to claim 1 wherein the semicrystalline polyolefin comprises a substantially isotactic homopolymer having a degree of atacticity of no more than 6 percent and possessing an average xylene soluble content of not more than 10 weight percent.

3. A metallised film according to claim 1 or 2 wherein the semicrystalline polyolefin is a substantially isotactic polypropylene homopolymer.

4. A metallised film according to any preceeding claim wherein the layer further comprises not more than 50 weight percent of a second substantially isotactic homopolymer having a degree of atacticity from 6% to 15%.

5. A metallised film according to any preceding claim wherein the layer further comprises not more than 34 weight percent of a C₂ to C₄ polymer which promotes adhesion of metal to the surface of the layer.

6. A metallised film according to claim 5 wherein the C₂ to C₄ polymer comprises a homo-, co-, or terpolymer.

7. A metallised film according to any preceding claim wherein the layer further comprises not more than 34 weight percent of a C₂ to C₄ polymer which promotes adhesion of metal to the surface of the layer and a second substantially isotactic homopolymer having a degree of atacticity from 6% to 15%, provided that the at least one substantially isotactic homopolymer is present in at least 50% by weight.

8. A metallised film according to any preceding claim wherein the treated surface is a gloss surface.

9. A metallised film according to claim 8 wherein the surface possesses a gloss of at least 75% at 45°.

10. A metallised film according to claim 9 wherein the surface possesses a gloss of at least 85% at 45°.

11. A metallised film according to any preceding claim which further comprises a core layer, one side of which is contiguous with the layer comprising at least one semicrystalline polyolefin.

12. A metallised film according to claim 11 which further comprises a heat sealable layer, one side of which is contiguous with the core layer.

13. A process for metallising a flexible film which comprises at least one layer of a polymeric material, which process comprises
(a) providing a layer comprising at least one semicrystalline polyolefin and containing from 0 to 50 weight percent of an amorphous polyolefin;
(b) treating a surface of the layer, prior to metallisation of that surface, by exposure to flame to enhance significantly the adhesion of the metal to the surface; and
(c) applying metal to the flame treated surface under vacuum metallising conditions.

14. A process according to claim 13 wherein the semicrystalline polyolefin is a substantially isotactic polypropylene homopolymer.

15. A process according to claims 13 or 14 wherein the film is oriented by stretching prior to steps (b) and (c).

16. A process according to any of claims 13 to 15 wherein flame treating of the surface imparts an energy density from 30 to 60 dynes/cm to this surface.

17. A process according to claim 16 wherein the energy density is from 35 to 55 dynes/cm.

18. A process according to any of claims 13 to 17 wherein the metal is aluminium.

19. A metallised flexible polymeric film comprising at least one layer possessing a glossy metal-receiving, polyolefin surface, said polyolefin containing at least 50 weight percent of a homopolymer and possessing an average xylene soluble content of not more than 10 weight percent.

20. The use of flame treatment to enhance the adhesion of metal to a surface comprising a major amount of a semicrystalline polyolefin.

## Patentansprüche

1. Metallisierter flexibler Film, der mindestens eine Schicht eines Polymermaterials aufweist, wobei die Schicht mindestens ein semikristallines Polyolefin, das 0 bis 50 Gew.-% eines amorphen Polyolefins enthält, umfaßt und eine Oberfläche aufweist, die vor ihrer Metallisierung dadurch behandelt worden ist, daß sie einer Flamme ausgesetzt wurde, um die Adhäsion des Metalls an der Oberfläche deutlich zu verbessern.

2. Metallisierter Film nach Anspruch 1, worin das semikristalline Polyolefin ein im wesentlichen isotaktisches Homopolymer enthält, das einen Grad an Ataktizität von nicht mehr als 6 % und einen durchschnittlichen Gehalt an xylollöslichen Bestandteilen von nicht mehr als 10 Gew.-% aufweist.

3. Metallisierter Film nach Anspruch 1 oder 2, worin das semikristalline Polyolefin ein im wesentlichen isotaktisches Polypropylenhomopolymer ist.

4. Metallisierter Film nach einem der vorstehenden Ansprüche, worin die Schicht ferner nicht mehr als 50 Gew.-% eines zweiten im wesentlichen isotaktischen Homopolymers mit einem Grad an Ataktizität von 6 bis 15 % enthält.

5. Metallisierter Film nach einem der vorstehenden Ansprüche, worin die Schicht ferner nicht mehr als 34 Gew.-% eines C₂- bis C₄-Polymers enthält, das die Adhäsion des Metalls an der Oberfläche der Schicht fördert.

6. Metallisierter Film nach Anspruch 5, worin das C₂- bis C₄-Polymer ein Homo-, Co- oder Terpolymer enthält.

7. Metallisierter Film nach einem der vorstehenden Ansprüche, worin die Schicht ferner nicht mehr als 34 Gew.-% eines C₂- bis C₄-Polymers, das die Adhäsion von Metall an der Oberfläche der Schicht fördert, und ein zweites im wesentlichen isotaktisches Homopolymer mit einem Grad an Ataktizität von 6 bis 15 % enthält, mit der Maßgabe, daß mindestens ein im wesentlichen isotaktisches Homopolymer in einer Menge von mindestens 50 Gew.-% vorliegt.

8. Metallisierter Film nach einem der vorstehenden Ansprüche, worin die behandelte Oberfläche eine Glanzoberfläche ist.

9. Metallisierter Film nach Anspruch 8, worin die Oberfläche einen Glanz von mindestens 75 % bei 45° aufweist.

10. Metallisierter Film nach Anspruch 9, worin die Oberfläche einen Glanz von mindestens 85 % bei 45° aufweist.

11. Metallisierter Film nach einem der vorstehenden Ansprüche, der ferner eine Kernschicht aufweist, deren eine Seite der Schicht angrenzt, die mindestens ein semikristallines Polyolefin enthält.

12. Metallisierter Film nach Anspruch 11, der ferner eine heißsiegelbare Schicht aufweist, deren eine Seite der Kernschicht angrenzt.

13. Verfahren zum Metallisieren eines flexiblen Films, der mindestens eine Schicht eines Polymermaterials enthält, wobei das Verfahren die folgenden Schritte beinhaltet:
(a) Bereitstellen einer Schicht, die mindestens ein semikristallines Polyolefin umfaßt und 0 bis 50 Gew.-% eines amorphen Polyolefins enthält;
(b) Behandeln einer Oberfläche der Schicht, vor dem Metallisieren dieser Oberfläche, durch Behandeln mit einer Flamme, um die Adhäsion des Metalls gegenüber der Oberfläche zu verbessern; und
(c) Aufbringen von Metall auf die flammbehandelte Oberfläche unter Bedingungen der Vakuummetallisierung.

14. Verfahren nach Anspruch 13, worin das semikristalline Polyolefin ein im wesentlichen isotaktisches Polypropylenhomopolymer ist.

15. Verfahren nach Anspruch 13 oder 14, worin der Film vor den Stufen (b) und (c) durch Recken orientiert wird.

16. Verfahren nach einem der Ansprüche 13 bis 15, worin durch die Flammbehandlung der Oberfläche diese Oberfläche einer Energiedichte von 30 bis 60 dyn/cm ausgesetzt wird.

17. Verfahren nach Anspruch 16, worin die Energiedichte 35 bis 55 dyn/cm beträgt.

18. Verfahren nach einem der Ansprüche 13 bis 17, worin das Metall Aluminium ist.

19. Metallisierter flexibler Polymerfilm, der mindestens eine Schicht enthält, die eine glänzende metallaufnehmende Polyolefinoberfläche aufweist, wobei das Polyolefin mindestens 50 Gew.-% eines Homopolymers und einen durchschnittlichen Gehalt an xylollöslichen Bestandteilen von nicht mehr als 10 Gew.-% aufweist.

20. Verwendung einer Flammbehandlung zur Verbesserung der Adhäsion von Metall gegenüber einer Oberfläche, die eine größere Menge eines semikristallinen Polyolefins enthält.

## Revendications

1. Un film souple métallisé qui comprend au moins une couche de matière polymère, la couche comprenant au moins une polyoléfine semi-cristalline contenant de 0 à 50% en poids de polyoléfine amorphe et ayant une surface traitée, avant la métallisation de ladite surface, par exposition à une flamme pour augmenter notablement l'adhérence du métal à la surface.

2. Un film métallisé selon la revendication 1, dans lequel la polyoléfine semi-cristalline comprend un homopolymère pratiquement isotactique ayant un degré d'atacticité non supérieur à 6% et présentant une teneur en produits solubles dans le xylène en moyenne non supérieure à 10% en poids.

3. Un film métallisé selon la revendication 1 ou 2, dans lequel la polyoléfine semi-cristalline est un homopolymère de propylène pratiquement isotactique.

4. Un film métallisé selon l'une quelconque des revendications précédentes, dans lequel la couche comprend en outre au plus 50% en poids d'un second homopolymère pratiquement isotactique ayant un degré d'atacticité de 6 à 15%.

5. Un film métallisé selon l'une quelconque des revendications précédentes, dans lequel la couche comprend en outre au plus 34% en poids d'un polymère en C₂ à C₄ qui favorise l'adhérence du métal à la surface de la couche.

6. Un film métallisé selon la revendication 5, dans lequel le polymère en C₂ à C₄ comprend un homo-, un co- ou un terpolymère.

7. Un film métallisé selon l'une quelconque des revendications précédentes, dans lequel la couche comprend en outre au plus 34% en poids de polymère en C₂ à C₄ qui favorise l'adhérence du métal à la surface de la couche, et un second homopolymère pratiquement isotactique ayant un degré d'atacticité de 6% à 15%, à condition que l'un au moins des homopolymères pratiquement isotactiques soit présent à raison d'au moins 50% en poids.

8. Un film métallisé selon l'une quelconque des revendications précédentes, dans lequel la surface traitée est une surface réfléchissante.

9. Un film métallisé selon la revendication 8, dans lequel la surface présente un pouvoir réfléchissant d'au moins 75% à 45°.

10. Un film métallisé selon la revendication 9, dans lequel la surface présente un pouvoir réfléchissant d'au moins 85% à 45°.

11. Un film métallisé selon l'une quelconque des revendications précédentes, qui comprend en outre une couche centrale, dont l'une des faces est contiguë à la couche comprenant au moins une polyoléfine semi-cristalline.

12. Un film métallisé selon la revendication 11, qui comprend en outre une couche thermosoudable, dont l'une des faces est contiguë à la couche centrale.

13. Un procédé de métallisation d'un film souple qui comprend au moins une couche d'une matière polymère, ledit procédé comprenant:
(a) l'utilisation d'une couche comprenant au moins une polyoléfine semi-cristalline et contenant de 0 à 50% en poids d'une polyoléfine amorphe;
(b) le traitement de la surface de la couche, avant la métallisation de ladite surface, par exposition à une flamme pour augmenter notablement l'adhérence du métal à la surface; et
(c) application de métal, sur la surface traitée à la flamme, dans des conditions de métallisation sous vide.

14. Un procédé selon la revendication 13, dans lequel la polyoléfine semi-cristalline est un homopolymère de polypropylène pratiquement isotactique.

15. Un procédé selon la revendication 13 ou 14, dans lequel le film est orienté par étirement avant les opérations de (b) et (c).

16. Un procédé selon l'une quelconque des revendications 13 à 15, dans lequel le traitement de surface à la flamme apporte une densité d'énergie de 30 à 70 dynes/cm à cette surface.

17. Un procédé selon la revendication 16, dans lequel la densité d'énergie est de 35 à 55 dynes/cm.

18. Un procédé selon l'une quelconque des revendications 13 à 17, dans lequel le métal est l'aluminium.

19. Un film polymère souple métallisé comprenant au moins une couche possédant une surface de polyoléfine recevant un métal réfléchissant, ladite polyoléfine contenant au moins 50% en poids d'un homopolymère et ayant une teneur en produits solubles dans le xylène de 10% en poids au plus.

20. L'utilisation du traitement à la flamme pour augmenter l'adhérence du métal sur une surface comprenant une proportion majeure de polyoléfine semi-cristalline.
